# FASCICULE DE BREVET EUROPEEN

(11) **EP 4 148 810 B1**
(45) Date de publication et mention de la délivrance du brevet: **04.11.2026**
(21) Numéro de dépôt: 22194979.5
(22) Date de dépôt: 09.09.2022
(51) Int. Cl.: H10F 55/10, H10F 55/20, H10F 55/00, H10W 90/00, H10H 29/30, H10K 59/95, H10K 39/00

(54) **DISPOSITIF OPTOÉLECTRONIQUE À COMPOSANTS ÉMISSIF ET PHOTODETECTEUR SUPERPOSÉS**
OPTOELEKTRONISCHE VORRICHTUNG MIT ÜBEREINANDER ANGEORDNETEN EMITTIERENDEN KOMPONENTEN UND FOTODETEKTOR
OPTOELECTRONIC DEVICE WITH STACKED EMISSIVE AND PHOTODETECTOR COMPONENTS

(30) Priorité: 13.09.2021 FR 2109581
(43) Date de publication de la demande: 15.03.2023
(73) Titulaire: Commissariat à l'Energie Atomique et aux Energies Alternatives, 75015 Paris (FR)
(72) Inventeur: TEMPLIER, François, 38054 Grenoble Cedex 09 (FR); MAINGUET, Jean-François, 38054 Grenoble Cedex 09 (FR); VIGIER, Margaux, 38054 Grenoble Cedex 09 (FR)
(74) Mandataire: Santarelli

(56) Documents cités:
- US-A1- 2006 007 220
- US-A1- 2018 269 240
- US-A1- 2019 346 939
- US-A1- 2020 161 520

## Description

### DOMAINE TECHNIQUE

L'invention concerne le domaine des dispositifs optoélectroniques combinant des fonctions d'affichage et de capture optique.

### ÉTAT DE LA TECHNIQUE ANTERIEURE

Plusieurs types de dispositifs optoélectroniques combinant des fonctions d'affichage et de capture optique existent, comprenant par exemple des LEDs ou des OLEDs pour réaliser la fonction d'affichage et des photodiodes organiques ou inorganiques pour capturer de la lumière du domaine visible et/ou infrarouge. Dans tous les types de dispositif, ces deux fonctions sont séparées latéralement l'une de l'autre, c'est-à-dire que vu depuis une face du dispositif depuis laquelle l'émission et la capture sont réalisées, les composants réalisant l'affichage ne chevauchent pas ceux réalisant la capture afin que tous les composants puissent émettre ou recevoir de la lumière depuis cette face. Or, cela limite la résolution atteignable par ces dispositifs.

De plus, lorsque de tels dispositifs intègrent une fonction de calibration, c'est-à-dire lorsque les composants photodétecteurs sont utilisés pour calibrer les composants émissifs, des réflexions successives de la lumière émise par les composants émissifs réalisant l'affichage sont nécessaires pour que la lumière atteigne les composants photodétecteurs réalisant la calibration, ce qui pose des problèmes d'efficacité et de performance.

Des exemples de dispositifs optoélectroniques combinant des fonctions d'affichage et de capture optique sont décrits dans les documents US 2006/007220 A1 et US 2019/346939 A1.

### EXPOSÉ DE L'INVENTION

Un but de la présente invention est de proposer un dispositif optoélectroniques ne présentant pas les inconvénients indiqués ci-dessus.

Pour cela, la présente invention propose un dispositif optoélectronique comprenant au moins :
- un composant émissif comportant au moins une première électrode, une deuxième électrode, et un élément émissif disposé entre une face émissive du dispositif optoélectronique et la deuxième électrode ;
- un composant photodétecteur tel que la deuxième électrode du composant émissif soit disposée entre le composant photodétecteur et l'élément émissif ;
dans lequel :
- le composant émissif et le composant photodétecteur sont superposés l'un au-dessus de l'autre, et
- la deuxième électrode est traversée par au moins un trou disposé à l'aplomb d'au moins une partie d'une surface de détection du composant photodétecteur et/ou une partie de la surface de détection du composant photodétecteur n'est pas disposée à l'aplomb de la deuxième électrode et forme une couronne se trouvant au niveau de bords extérieurs de la surface de détection du composant photodétecteur.

Dans ce dispositif optoélectronique, le composant émissif et le composant photodétecteur sont superposés l'un au-dessus de l'autre. La superposition des composants émissif et photodétecteur signifie qu'au moins une partie de l'élément émissif du composant émissif est disposée à l'aplomb, ou en face, du composant photodétecteur. Grâce à cette superposition des composants émissif et photodétecteur, la partie de la surface émissive dédiée uniquement à la fonction de détection lumineuse est très faible. Aucun espace n'est dédié spécifiquement aux composants photodétecteurs, ce qui autorise de réaliser plusieurs composants émissifs les uns à côté des autres avec une importante résolution. De plus, la perte de luminosité du composant émissif engendrée par la présence du composant photodétecteur est minime. Enfin, lorsque le composant photodétecteur est destiné à détecter au moins une partie de la lumière émise par le composant émissif, comme par exemple lorsque le composant photodétecteur est destiné à servir à la calibration du composant émissif, la lumière captée par le composant photodétecteur ne subit pas de réflexions à travers le dispositif optoélectronique, garantissant ainsi une bonne efficacité et de bonnes performances du dispositif optoélectronique.

Ce dispositif optoélectronique propose donc de réaliser un ou plusieurs pixels bidirectionnels dont les fonctions d'émission lumineuse et de capture optique sont intégrées verticalement l'une au-dessus de l'autre.

Dans une configuration particulière, une partie seulement de la surface de détection du composant photodétecteur n'est pas disposée à l'aplomb de la deuxième électrode. Autrement dit, une autre partie de la surface de détection du composant photodétecteur est disposée à l'aplomb de la deuxième électrode.

La face émissive du dispositif optoélectronique correspond à la face du dispositif optoélectronique à travers laquelle le ou les composants émissifs émettent de la lumière.

Le composant photodétecteur peut faire partie d'un circuit intégré ou d'un module électronique comprenant d'autres composants électroniques configurés pour commander au moins le composant photodétecteur et le composant émissif et/ou mémoriser au moins une valeur de mesure destinée à être délivrée en sortie du composant photodétecteur.

Le composant photodétecteur peut être configuré pour mesurer une valeur de luminosité du composant émissif et/ou une valeur de luminosité d'une lumière reçue à travers la face émissive du dispositif optoélectronique.

Le dispositif optoélectronique peut comporter en outre au moins un dispositif de calcul de compensation d'un signal de commande du composant émissif en fonction au moins de la valeur de luminosité mesurée du composant émissif.

Dans un premier mode de réalisation, le trou peut comporter, dans un plan parallèle à la surface de détection du composant photodétecteur, une section circulaire.

Dans un deuxième mode de réalisation, la partie de la surface de détection du composant photodétecteur qui n'est pas disposée à l'aplomb de la deuxième électrode forme une couronne se trouvant au niveau de bords extérieurs de la surface de détection du composant photodétecteur.

Dans une autre configuration décrite ici à titre d'exemple, le dispositif optoélectronique peut être tel que :
- le composant émissif fait partie d'un ensemble de composants émissifs disposés les uns à côté des autres et comportant chacun au moins une première électrode, une deuxième électrode, et un élément émissif disposé entre la face émissive du dispositif optoélectronique et la deuxième électrode, et
- une partie de la surface de détection du composant photodétecteur n'est pas disposée à l'aplomb de la deuxième électrode de chacun des composants émissifs.

De manière avantageuse, le composant émissif peut faire partie d'une matrice de composants émissifs, et peut comprendre en outre plusieurs autres composants photodétecteurs tels que la deuxième électrode d'au moins une partie des composants émissifs soit traversée par au moins un trou disposé à l'aplomb d'au moins une partie d'une surface de détection d'un des composants photodétecteurs et/ou tels qu'une partie de la surface de détection d'un des composants photodétecteurs ne soit pas disposée à l'aplomb de la deuxième électrode d'au moins un des composants émissifs.

Le dispositif optoélectronique peut comporter en outre au moins :
- une première couche diélectrique recouvrant au moins les composants photodétecteurs et des premiers plots de connexion disposés dans la première couche diélectrique ;
- une deuxième couche diélectrique recouvrant au moins les composants émissifs et des deuxièmes plots de connexion disposés dans la deuxième couche diélectrique ;
et dans lequel la première couche diélectrique est solidarisé à la deuxième couche diélectrique, et les premiers plots de connexion sont solidarisés aux deuxièmes plots de connexion.

Dans cette configuration, lorsque le composant photodétecteur fait partie d'un circuit intégré, les premiers plots de connexions peuvent être couplés électriquement à des portions d'un niveau d'interconnexions du circuit intégré par des vias.

En variante, les composants émissifs et les composants photodétecteurs peuvent former des modules distincts les uns des autres, reportés sur un support et comprenant chacun au moins un des composants émissifs et un des composants photodétecteurs.

L'invention concerne également un procédé de réalisation d'un dispositif optoélectronique, comprenant au moins :
- réalisation d'au moins un composant émissif comportant au moins une première électrode, une deuxième électrode, et un élément émissif disposé entre une face émissive du dispositif optoélectronique et la deuxième électrode ;
- réalisation d'au moins un composant photodétecteur tel que la deuxième électrode du composant émissif soit disposée entre le composant photodétecteur et l'élément émissif, et tel que le composant émissif et le composant photodétecteur soient superposés l'une au-dessus de l'autre ;
et dans lequel la deuxième électrode est traversée par au moins un trou disposé à l'aplomb d'au moins une partie d'une surface de détection du composant photodétecteur et/ou dans lequel une partie de la surface de détection du composant photodétecteur n'est pas disposée à l'aplomb de la deuxième électrode et forme une couronne se trouvant au niveau de bords extérieurs de la surface de détection du composant photodétecteur.

Le composant photodétecteur peut être réalisé dans un circuit intégré ou un module électronique comprenant d'autres composants électroniques configurés pour commander au moins le composant photodétecteur et le composant émissif et/ou mémoriser au moins une valeur de mesure destinée à être délivrée en sortie du composant photodétecteur.

Le procédé peut comporter en outre :
- après la réalisation du composant photodétecteur, la réalisation d'au moins une première couche diélectrique recouvrant au moins le composant photodétecteur et la réalisation de premiers plots de connexion dans la première couche diélectrique ;
- après la réalisation du composant émissif, la réalisation d'au moins une deuxième couche diélectrique recouvrant au moins le composant émissif et la réalisation de deuxièmes plots de connexion dans la deuxième couche diélectrique ;
- solidarisation par collage direct de la première couche diélectrique contre la deuxième couche diélectrique, et des premiers plots de connexion contre les deuxièmes plots de connexion.

Par collage direct, on entend ici un collage de type moléculaire, sans apport de matière adhésive ou de brasure à l'interface entre les éléments solidarisés par un tel collage. Dans le cas d'un collage direct, une fois les deux éléments alignés, une simple mise en contact de ces éléments suffit à figer la position finale de l'un par rapport à l'autre. Autrement dit, le collage est instantané. Ceci constitue une différence par rapport à un collage avec apport de matière, par exemple par brasure, dans lequel une étape de compression et/ou de chauffage doit être mise en œuvre après l'alignement et la mise en contact des deux circuits, ce qui peut conduire à un désalignement des circuits. Le collage direct peut être hydrophobe ou hydrophile.

Le dispositif optoélectronique peut être utilisé pour différentes applications :
- calibration d'écran, écran auto-calibré ;
- système mesure et contrôle d'éclairage ;
- éclairage intelligent ;
- écran interactif avec capture de visage et/ou de mouvement et/ou d'identification et/ou de reconnaissance.

Dans l'ensemble du document, le terme « sur » est utilisé sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1 représente schématiquement un dispositif optoélectronique selon un premier mode de réalisation ;
Les figures 2 à 5 représentent schématiquement une vue de dessus de la deuxième électrode d'un composant émissif et du composant photodétecteur d'un dispositif optoélectronique selon différentes configurations ;
Les figures 6 à 14 représentent schématiquement des étapes d'un procédé de réalisation du dispositif optoélectronique selon le premier mode de réalisation ;
La figure 15 représente un autre exemple de réalisation du dispositif optoélectronique selon le premier mode de réalisation ;
La figure 16 représente un exemple de réalisation d'un dispositif de calcul de compensation d'une tension de commande d'un composant émissif en fonction de la valeur de luminosité mesurée de ce composant émissif ;
Les figures 17 à 19 représentent différentes configurations d'un dispositif électronique selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSE DETAILLE DE MODES DE REALISATION PARTICULIERS

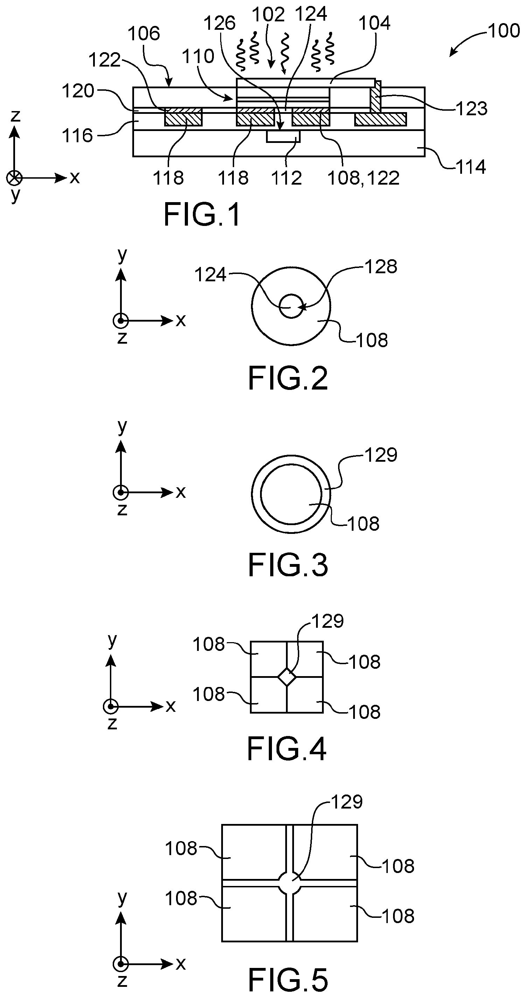

La figure 1 est une vue en coupe représentant schématiquement un dispositif optoélectronique 100 selon un premier mode de réalisation.

Le dispositif 100 comporte au moins un composant émissif 102 correspondant par exemple à une LED ou une OLED. Le composant émissif 102 est par exemple apte à émettre de la lumière dans le domaine visible et/ou infrarouge. Ce composant émissif 102 comporte une première électrode 104 disposée du côté d'une face émissive 106 du dispositif 100, c'est-à-dire du côté de la face du dispositif 100 par laquelle le composant émissif 102 est destiné à émettre de la lumière. La première électrode 104 est au moins partiellement transparente à la lumière destinée à être émise par le composant émissif 102, et également au moins partiellement transparente à la lumière (domaine visible et/ou infrarouge) destinée à être reçue depuis l'extérieur du dispositif 100 à travers la face émissive 106 et captée par un composant photodétecteur 112 du dispositif 100 lorsque ce composant photodétecteur 112 est destiné à capter la lumière provenant de l'extérieur du dispositif 100. La première électrode 104 peut comporter par exemple un oxyde transparent conducteur tel que de l'ITO (oxyde d'indium-étain).

Le composant émissif 102 comporte également une deuxième électrode 108 et au moins un élément émissif 110 disposé entre les première et deuxième électrodes 104, 108. La deuxième électrode 108 n'est pas transparente, mais réfléchissante vis-à-vis de la lumière destinée à être émise par le composant émissif 102 et de la lumière reçue par le dispositif 100 à travers la face émissive 106. Par exemple, la deuxième électrode 108 comporte du métal. L'élément émissif 110 correspond par exemple à un empilement de matériaux formant une jonction p-n avec, entre les portions de semi-conducteurs dopés p et n, un ou plusieurs matériaux semi-conducteurs formant un ou plusieurs puits quantiques superposés les uns au-dessus des autres. Le ou les matériaux de l'élément émissif 110 correspondent avantageusement à au moins l'un des matériaux semi-conducteurs suivants : AlInGaN, InGaN, AlGaN, GaN.

Le dispositif 100 comporte également au moins un composant photodétecteur 112, par exemple une photodiode organique ou inorganique. Dans l'exemple de réalisation représenté sur la figure 1, ce composant photodétecteur 112 fait partie d'un circuit intégré 114 comprenant d'autres composants électroniques, par exemple de type CMOS, configurés pour commander le composant émissif 102 et le composant photodétecteur 112. Le composant émissif 102 est solidarisé au circuit intégré 114.

Le circuit intégré 114 comporte un ou plusieurs niveaux d'interconnexions, non visibles sur la figure 1, comportant avantageusement des portions métalliques, reliant électriquement le composant émissif 102 et le composant photodétecteur 112 aux autres composants électroniques du circuit intégré 114.

Sur l'exemple de réalisation représenté sur la figure 1, le circuit intégré 114, et donc le composant photodétecteur 112, est solidarisé au composant émissif 102 par collage direct hybride. Pour cela, une première couche diélectrique 116 est disposée au-dessus du composant photodétecteur 112 (contre le composant photodétecteur 112 sur l'exemple de la figure 1), et des premiers plots de connexion 118 sont formés dans la première couche diélectrique 116. De plus, une deuxième couche diélectrique 120 est disposée sous le composant émissif 102 (contre le composant émissif 102 sur l'exemple de la figure 1) et des deuxièmes plots de connexion 122 sont formés dans la deuxième couche diélectrique 120. Les couches diélectriques 116, 120 sont au moins partiellement transparentes à la lumière destinée à être émise par le composant émissif 102, et également au moins partiellement transparente à la lumière (domaine visible et/ou infrarouge) destinée à être reçue depuis l'extérieur du dispositif 100 à travers la face émissive 106 et captée par un composant photodétecteur 112 du dispositif 100 lorsque ce composant photodétecteur 112 est destiné à capter la lumière provenant de l'extérieur du dispositif 100.

Ainsi, la première couche diélectrique 116 est disposée entre le composant photodétecteur 112 et la deuxième couche diélectrique 120, la deuxième couche diélectrique 120 est disposée entre la première couche diélectrique 116 et le composant émissif 102, et les première et deuxième couches diélectriques 116, 120 sont disposées entre les composants émissif et photodétecteur 102, 112.

Les premiers et deuxièmes plots de connexion 118, 122 comportent avantageusement du métal. Au moins l'un des deuxièmes plots de connexion 122 est disposé et solidarisé contre la deuxième électrode 108. Sur la figure 1, la deuxième électrode 108 et le deuxième plot de connexion 122 formé contre celle-ci sont représentés sous la forme d'un seul élément.

Le collage direct hybride réalisé correspond à un collage direct diélectrique - diélectrique du matériau de la première couche diélectrique 116 contre celui de la deuxième couche diélectrique 120, et un collage direct métal - métal des premiers plots de connexion 118 contre les deuxièmes plots de connexion 122.

Pour obtenir un collage direct hybride de bonne qualité, il est préférable qu'au niveau des faces solidarisées l'une contre l'autre, le taux d'occupation des plots de connexion 118, 122 sur chacune de ces faces soit de préférence compris entre 60 % et 90 % de zone conductrice dans la région de ces faces formant la zone active du dispositif 100, c'est-à-dire la région dans laquelle est formée la matrice de composants émissifs 102 et photodétecteur 112, et que la répartition des plots de connexion 118, 122 sur ces faces de connexion (dans la zone active et éventuellement en dehors de la zone active) soit relativement homogène, c'est-à-dire que les plots de connexions 118, 122 ne soient pas localisés dans une partie seulement de ces faces mais dans l'ensemble de ces faces. Préalablement à l'étape de collage proprement dite, les faces de connexion sont planarisées par polissage mécano-chimique (CMP). La planéité de surface obtenue lors de cette étape conditionne également la qualité du collage direct hybride réalisé.

Bien que cela ne soit pas visible sur la figure 1, au moins une partie des premiers plots de connexion 118 sont reliés électriquement aux niveaux d'interconnexions du circuit intégré 114 par l'intermédiaire de vias, assurant ainsi des liaisons électriques entre les électrodes 104, 108 du composant émissif 102 et l'électronique de commande formée dans le circuit intégré 114. Sur la figure 1, la deuxième électrode 108 du composant émissif 102 est couplée électriquement à des premier et deuxième plots de connexion 118, 122 avec lesquels la deuxième électrode 108 est en contact, et la première électrode 104 est couplée électriquement à d'autres premier et deuxième plots de connexion 118, 122 par l'intermédiaire d'un via 123.

Le composant émissif 102 et le composant photodétecteur 112 sont superposés l'un au-dessus de l'autre. Or, le composant photodétecteur 112 est destiné à réaliser une capture de lumière entrant dans le dispositif optoélectronique 100 depuis la face émissive 106 et/ou d'une partie de la lumière émise par le composant émissif 102. Dans le premier mode de réalisation décrit ici, pour que cette capture puisse est réalisée, la deuxième électrode 108 (qui est formé d'au moins un matériau au moins partiellement réflecteur) est traversée par au moins un trou 124 disposé à l'aplomb d'au moins une partie 128 d'une surface de détection 126 du composant photodétecteur 112, permettant à de la lumière d'entrer dans le dispositif optoélectronique 100 depuis la face émissive 106 et d'atteindre le composant photodétecteur 112 en traversant le composant émissif 102 et en passant dans le trou 124, et/ou à de la lumière émise depuis le composant émissif 102, et plus particulièrement depuis son côté se trouvant en regard du composant photodétecteur 112, d'être captée par le composant photodétecteur 112 à travers le trou 124.

La figure 2 représente schématiquement une vue de dessus de la deuxième électrode 108 du composant émissif 102 et du composant photodétecteur 112 d'un dispositif optoélectronique 100 selon ce premier mode de réalisation. Dans l'exemple de réalisation décrit ici, le trou 124 comporte, dans un plan parallèle à la surface de détection 126 du composant photodétecteur 112, une section circulaire. D'autres formes de section du trou 124 sont toutefois possibles.

Suivant l'application envisagée pour le composant photodétecteur 112, les dimensions du trou 124 peuvent varier. Ainsi, selon un premier exemple, lorsque le composant photodétecteur 112 est utilisé pour réaliser une calibration du composant émissif 102 en mesurant une valeur de luminosité du composant émissif 102, le trou 124 peut avoir un diamètre égal à environ un dixième de la dimension d'un côté du composant émissif 102 (par exemple un diamètre égal à 1 µm lorsque les dimensions des côtés du composant émissif 102 sont égales à 10 µm). Dans ce cas, la perte de luminosité du composant émissif 102 est très faible du fait que seulement 1% de la surface inférieure de l'élément émissif 110 n'est pas en contact avec la deuxième électrode 108. Selon un deuxième exemple, lorsque le composant photodétecteur 112 est utilisé pour réaliser une capture de lumière extérieure entrant dans le dispositif optoélectronique 100 depuis sa face émissive 106, par exemple pour réaliser une détection de présence devant le dispositif optoélectronique 100, le trou 124 peut avoir un diamètre égal à environ quatre dixièmes de la dimension d'un côté du composant émissif 102 (par exemple un diamètre égal à 4 µm lorsque les dimensions des côtés du composant émissif 102 sont égales à 10 µm). Dans ce cas, la perte de luminosité du composant émissif 102 est également très faible du fait que seulement 16% de la surface inférieure de l'élément émissif 110 n'est pas en contact avec la deuxième électrode 108.

Dans un deuxième mode de réalisation, le dispositif optoélectronique 100 peut comporter un composant émissif 102 dont la deuxième électrode 108 n'est pas traversée par un trou. Dans ce cas, afin que le composant photodétecteur 112 puisse réaliser une capture de lumière entrant dans le dispositif optoélectronique 100 depuis la face émissive 106 et/ou une capture d'une partie de la lumière émise par le composant émissif 102, une partie 129 de la surface de détection 126 du composant photodétecteur 112 n'est pas disposée à l'aplomb de la deuxième électrode 108 du composant émissif 102.

La figure 3 représente schématiquement une vue de dessus de la deuxième électrode 108 d'un composant émissif 102 et du composant photodétecteur 112 d'un dispositif optoélectronique 100 d'un exemple de ce deuxième mode de réalisation. Sur l'exemple représenté sur la figure 3, la partie 129 de la surface de détection 126 qui n'est pas disposée à l'aplomb de la deuxième électrode 108 forme une couronne se trouvant au niveau des bords extérieurs de la surface 126.

Selon une variante de ce deuxième mode de réalisation, il est possible que la partie 129 de la surface de détection 126 qui n'est pas disposée à l'aplomb de la deuxième électrode 108 forme une portion seulement d'une couronne se trouvant au niveau des bords extérieurs de la surface 126.

Dans une autre configuration décrite à titre d'exemple, le composant émissif 102 fait partie d'un ensemble de composants émissifs 102 disposés les uns à côté des autres et comportant chacun au moins une première électrode 104 disposée du côté de la face émissive 106, une deuxième électrode 108, et un élément émissif 110 disposé entre les première et deuxième électrodes 104, 108, et une partie 129 de la surface de détection 126 du composant photodétecteur 112 n'est pas disposée à l'aplomb de la deuxième électrode 108 de chacun de ces composants émissifs 102.

La figure 4 représente schématiquement une vue de dessus des deuxièmes électrodes 108 d'un tel ensemble de composants émissifs 102 selon cet exemple. Sur l'exemple de la figure 4, ces composants émissifs 102 sont disposés sous la forme d'une matrice 2 x 2, et la partie 129 de la surface de détection 126 qui n'est pas disposée à l'aplomb des deuxièmes électrodes 108 est localisée à l'aplomb du centre de cette matrice au niveau duquel chacune des deuxièmes électrodes 108 est rognée afin de former un trou à travers lequel la partie 129 de la surface de détection 126 est accessible pour de la lumière se dirigeant vers cette surface de détection 126.

Sur le schéma de la figure 4, les deuxièmes électrodes 108 sont représentées comme étant adjacentes, ou en contact, deux à deux. Toutefois, lorsque les composants émissifs 102 sont commandables indépendamment les uns des autres, les deuxièmes électrodes 108 ne sont pas en contact deux à deux. La figure 5 représente schématiquement une telle configuration. Dans ce cas, de la lumière peut atteindre la surface de détection 126 du composant photodétecteur 112 si celle-ci est présente à l'aplomb des espaces séparant les deuxièmes électrodes 108. En variante, il est possible de bloquer la lumière passant entre les deuxièmes électrodes 108 en interposant des portions métalliques d'un ou plusieurs niveaux d'interconnexions localisés entre les composants émissifs 102 et les composants photodétecteurs 112.

De manière avantageuse, le dispositif optoélectronique 100 comporte plusieurs composants émissifs 102 disposés en matrice (formant avantageusement un écran) et plusieurs composants photodétecteurs 112 tels que la deuxième électrode 108 de chacun des composants émissifs 102, ou d'une partie seulement de ces composants émissifs 102, soit traversée par au moins un trou 124 disposé à l'aplomb d'au moins une partie 128 d'une surface de détection 126 d'un des composants photodétecteurs 112 et/ou tels qu'une partie 129 de la surface de détection 126 d'un des composants photodétecteur 112 ne soit pas disposée à l'aplomb de la deuxième électrode 108 d'un ou plusieurs des composants émissifs 102.

Lorsque le ou les composants photodétecteurs 112 sont configurés pour réaliser une capture d'une partie de la lumière émise par le ou les composants émissifs 102 et une calibration du ou des composants émissifs 102, le dispositif optoélectronique 100 peut comporter en outre au moins un dispositif de calcul de compensation d'un signal de commande, par exemple une tension de commande, du ou des composants émissif 102 en fonction de la valeur de luminosité mesurée du ou des composants émissifs 102. Dans la configuration représentée sur la figure 1, ce ou ces dispositifs de calcul de compensation sont par exemple formés par des composants électroniques du circuit intégré 114. Le dispositif optoélectronique 100 peut également comporter une ou plusieurs mémoires dans lesquelles la ou les valeurs représentatives de la luminosité mesurées par le ou les composants photodétecteurs 112 sont stockées. Cette ou ces mémoires sont par exemple formés par d'autres composants électroniques du circuit intégré 114.

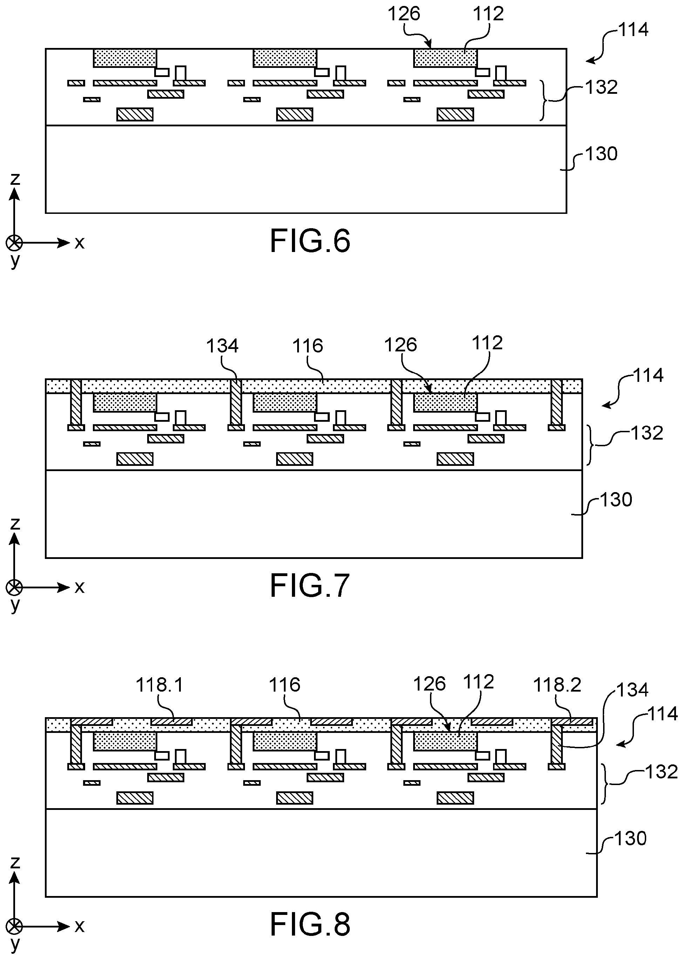

Un procédé de réalisation du dispositif optoélectronique 100 selon le premier mode de réalisation est décrit ci-dessous en lien avec les figures 6 à 14.

Dans ce procédé, les composants photodétecteurs 112 sont réalisés tels qu'ils fassent partie du circuit intégré 114. Sur la figure 6, ce circuit intégré 114 comporte un premier substrat 130 à partir duquel des composants électroniques CMOS, non visibles sur la figure 6, sont réalisés. Ces composants sont notamment destinés à former l'électronique de commande du dispositif optoélectronique 100, et éventuellement le ou les dispositifs de calcul de compensation et la ou les mémoires décrites ci-dessus. Plusieurs niveaux d'interconnexions 132 sont réalisés sur le premier substrat 130. Dans ce procédé de réalisation, les composants photodétecteurs 112 sont réalisés sous la forme d'un capteur CMOS dit « Backside », c'est-à-dire tel que les surfaces de détection 126 des composants photodétecteurs 112 correspondent aux faces arrières de ces composants et dans lequel les niveaux d'interconnexions 132 sont disposés entre les composants photodétecteurs 112 et le premier substrat 130. De plus, dans l'exemple de réalisation décrit ici, les composants photodétecteurs 112 sont agencés en matrice.

Comme représenté sur la figure 7, la première couche diélectrique 116 est déposée sur la face du circuit intégré 114 au niveau de laquelle les composants photodétecteurs 112 sont disposés, recouvrant ainsi les composants photodétecteurs 112.

Des ouvertures sont ensuite gravées à travers la première couche diélectrique 116 et une partie de l'épaisseur du matériau diélectrique dans lequel se trouvent les niveaux d'interconnexions 132. Du matériau métallique est ensuite déposé dans ces ouvertures de manière à former des vias conducteurs 134 auxquels les première et deuxième électrodes 104, 108 des composants émissifs 102 sont destinées à être reliées électriquement.

Les premiers plots de connexion 118 sont ensuite réalisés dans la première couche diélectrique 116, par exemple en gravant des cavités dans la première couche diélectrique 116 et en remplissant ces cavités par un matériau métallique, par exemple du cuivre, par un procédé de type damascene. Sur la figure 8, seule une partie des premiers plots de connexion 118 sont représentés. Dans cet exemple, les premiers plots de connexion portant la références 118.1 ont une forme sensiblement similaire à celle des deuxièmes électrodes 108 des composants émissifs 102 qui seront disposés ultérieurement à l'aplomb des composants photodétecteurs 112. Ainsi, sur la figure 8, les premiers plots de connexion 118.1 ont une forme annulaire et ont en leur centre un trou disposé à l'aplomb d'une partie de la surface de détection 126 des composants photodétecteurs 112. De plus, ces premiers plots de connexion 118.1 sont couplés électriquement aux vias 134 et serviront par la suite pour former les connexions électriques aux deuxièmes électrodes 108 des composants émissifs 102 qui formeront les anodes des composants émissifs 102. Au moins un autre premier plot de connexion, désigné par la référence 118.2, est destiné à être relié électriquement aux premières électrodes 104 des composants émissifs 102 qui seront réalisées de manière à former une cathode commune à tous les composants émissifs 102.

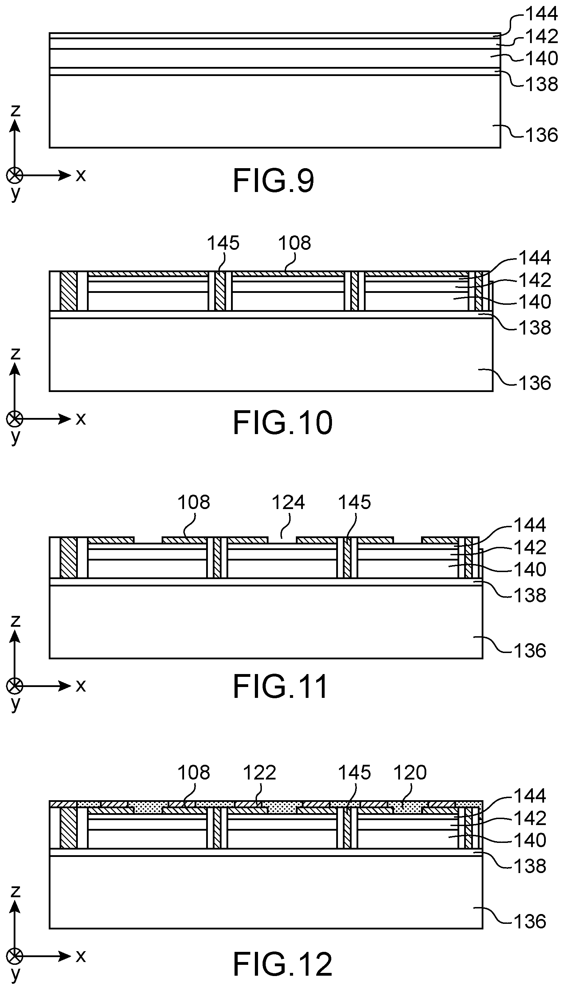

Parallèlement à la réalisation du circuit intégré 114 et des premiers plots de connexion 118, une matrice de composants émissifs 102 est réalisée sur un deuxième substrat 136 (voir figure 9). Dans l'exemple de réalisation décrit ici, les composants émissifs correspondent à des LEDs réalisées en formant, sur le deuxième substrat 136 et par épitaxie, un empilement de couches comprenant une couche tampon 138, une couche de semi-conducteur dopé n 140, une ou plusieurs couches de semi-conducteur intrinsèque (non dopé intentionnellement) 142 formant un ou plusieurs puits quantiques (avec par exemple une ou plusieurs couche émissives chacune disposée entre deux couches barrières), ainsi qu'une couche de semi-conducteur dopé p 144. Les matériaux des couches 138, 140, 142 et 144 correspondent par exemple à de l'AlInGaN et/ou de l'InGaN et/ou de l'AlGaN et/ou du GaN.

Comme représenté sur la figure 10, des tranchées délimitant latéralement les composants émissifs 102 les uns des autres sont ensuite réalisées à travers les couches 144, 142 et 140. Un matériau électriquement conducteur 145, par exemple métallique, est ensuite déposé dans les tranchées. Ce matériau conducteur 145 est destiné à former une grille autour des composants émissifs 102 et à bien drainer le courant de cathode commune de ces composants émissifs 102. Les composants émissifs 102 sont agencés en formant une matrice similaire à celle formée par les composants photodétecteurs 112. Le matériau conducteur 145 est entouré latéralement par du matériau diélectrique afin d'isoler électriquement ce matériau conducteur 145 vis-à-vis des couches 140, 142 et 144. Les deuxièmes électrodes 108 sont également réalisées sur la couche 144 et ne sont pas en contact avec le matériau conducteur 145.

Des trous 124 sont ensuite gravés à travers les deuxièmes électrodes 108 (voir figure 11). Les dimensions des trous 124 sont choisies en fonction de l'application souhaitée pour les composants photodétecteurs 112 (mesure de luminosité extérieure au dispositif 100 et/ou mesure de luminosité des composants émissifs 102) et donc de la surface de capture nécessaire aux composants photodétecteurs 112.

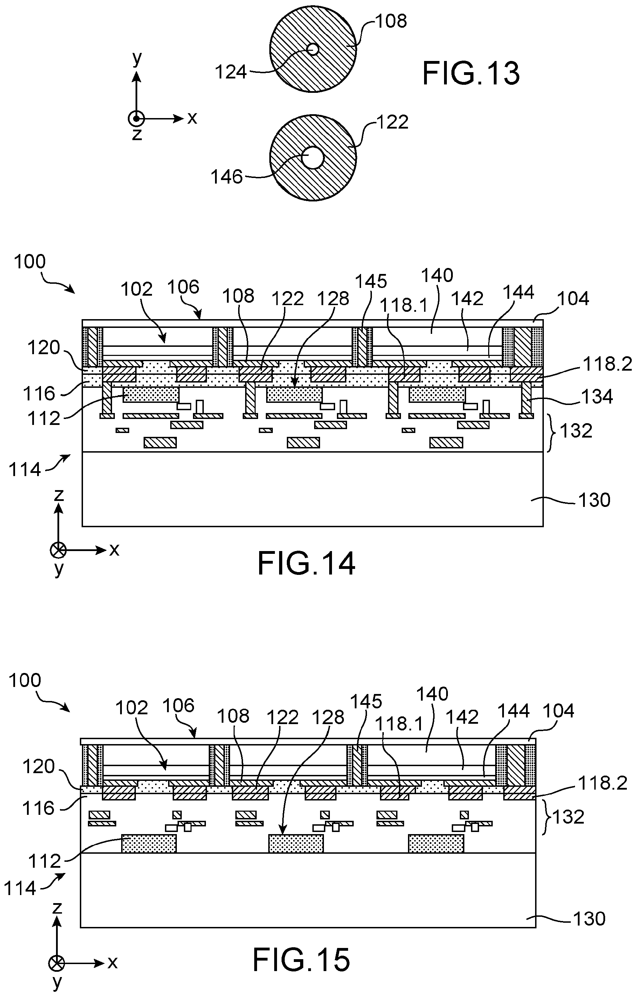

La deuxième couche diélectrique 120 est ensuite réalisée sur la structure précédemment réalisée, recouvrant notamment les faces supérieures des deuxièmes électrodes 108 et des portions de matériau électriquement conducteur 145, et remplissant les trous 124. Les deuxièmes plots de connexion 122 sont ensuite réalisés dans la deuxième couche diélectrique 120, sur les deuxièmes électrodes 108 et sur au moins l'une des portions de matériau électriquement conducteur 145 se trouvant en périphérie de la matrice de composants émissifs 102 (voir figure 12). Dans l'exemple de réalisation décrit ici, les deuxièmes plots de connexion 122 réalisés sur les deuxièmes électrodes 108 ont, dans un plan parallèle à la surface des deuxièmes électrodes 108 sur lesquelles les deuxièmes plots de connexion 122 sont réalisés, une section de forme sensiblement similaire à celles des deuxièmes électrodes 108. Ainsi, dans l'exemple de réalisation décrit ici, cette section est de forme annulaire, avec au centre un trou 146 de dimensions supérieures ou égales à celle du trou 124. La figure 13 représente schématiquement une vue de dessus de l'une des deuxièmes électrodes 108 traversée par l'un des trous 124 et de l'un des deuxièmes plots de connexion 122 traversé par un trou 146.

Un collage direct hybride est ensuite mis en œuvre entre les deux structures réalisées, avec une mise en contact des premiers et deuxièmes plots de connexion 118, 122, et une mise en contact des matériaux des première et deuxième couches diélectriques 116, 120. Préalablement à cette mise en contact, les surfaces destinées à être mises en contact subissent une planarisation mécano-chimique afin d'obtenir des états de surface permettant la mise en œuvre du collage direct.

Chacun des trous formés dans la couche servant à la réalisation des premiers plots de connexion 118.1 est destiné à être aligné avec l'un des trous 124 et l'un des trous 146. Du fait des erreurs d'alignement pouvant se produire, notamment lors du collage entre les deux structures, l'un de ces trois trous peut avantageusement être sensiblement plus petit que les deux autres. Dans l'exemple décrit ici en lien avec les figures 6 à 14, les trous 124 ont de plus petites dimensions que les trous 146 et les trous formés dans la couche servant à la réalisation des premiers plots de connexion 118.1. Ainsi, même si des erreurs d'alignement se produisent, la dimension effective du passage lumineux formé pour chaque composant photodétecteur 112 n'est pas affecté par ces erreurs d'alignement et est de valeur fixe et définie par les dimensions du plus petit des trois trous. Cette garantie des dimensions pour le passage de la lumière jusqu'aux composants photodétecteurs 112 est très avantageuse, notamment lorsque les composants photodétecteurs 112 sont utilisés pour calibrer les composants émissifs.

Le deuxième substrat 136 est ensuite supprimé, par exemple par meulage lorsque le deuxième substrat 136 comporte du silicium ou par retrait laser, ou « laser lift-off » en anglais, lorsque le deuxième substrat 136 comporte du saphir.

La couche tampon 138 est ensuite retirée, puis les premières électrodes 104 sont réalisées par exemple par dépôt d'un ou plusieurs matériaux, par exemple d'ITO. Sur la figure 14, les premières électrodes 104 correspondent à une couche d'ITO déposée à la place de la couche tampon 138, reliée électriquement aux portions de matériau électriquement conducteur 145 et formant une cathode commune des composants émissifs 102.

Le dispositif optoélectronique 100 achevé est représenté sur la figure 14. De manière optionnelle, il est possible de mettre en œuvre d'autres étapes, comme par exemple la réalisation d'éléments de conversion de longueur d'onde lumineuse, d'éléments d'extraction lumineuse, ou encore de lentilles, sur la face émissive 106 et avantageusement à l'échelle du dispositif optoélectronique 100. Ces éléments optiques peuvent servir à la fonction émissive et/ou la fonction de capture lumineuse du dispositif 100.

Dans le procédé décrit ci-dessus, les composants photodétecteurs 112 sont réalisés sous la forme d'un capteur CMOS dit « Backside », c'est-à-dire tel que les surfaces de détection 126 des composants photodétecteurs 112 correspondent aux faces arrières de ces composants 112 et dans lequel les niveaux d'interconnexions 132 sont disposés entre les composants photodétecteurs 112 et le premier substrat 130. En variante, les composants photodétecteurs 112 peuvent être réalisés sous la forme d'un capteur CMOS dit « Frontside », c'est-à-dire tel que les surfaces de détection 126 des composants photodétecteurs 112 correspondent aux faces avant de ces composants 112 et dans lequel les composants photodétecteurs 112 sont disposés entre les niveaux d'interconnexions 132 et le premier substrat 130. La figure 15 représente un exemple de réalisation du dispositif optoélectronique 100 dans lequel les composants photodétecteurs 112 sont réalisés sous la forme d'un capteur CMOS dit « Frontside ».

Selon un exemple de réalisation alternatif de celui représenté sur la figure 1, et qui peut s'appliquer aux différents modes de réalisation, les composants émissifs 102 et les composants photodétecteurs 112 peuvent former des modules distincts les uns des autres, reportés sur un support et comprenant chacun au moins un des composants émissifs 102, un des composants photodétecteurs 112 et d'autres composants électroniques formant par exemple le dispositif de calcul de compensation de la tension de commande du dispositif émissif en fonction de la valeur de luminosité mesurée du composant émissif. De tels modules peuvent être réalisés comme décrit dans les documents EP 3 381 060 A1 et « A New Approach for Fabricating High-Performance MicroLED Displays » de F. Templier et al., SID Symposium Digest of Technical Papers, Volume 50 (1), June 1, 2019. Par exemple, les composants émissifs 102, les composants photodétecteurs 112 et les autres composants électroniques peuvent être réalisés sur différents substrats, puis découpés, assemblés sous forme de modules distincts et enfin reportés sur un support correspondant par exemple à un ou plusieurs circuits imprimés.

Comme déjà indiqué précédemment, les composants photodétecteurs 112 du dispositif optoélectronique 100 peuvent servir à réaliser une calibration des composants émissifs 102 du dispositif optoélectronique 100. Une telle calibration peut par exemple servir à configurer les composants émissifs 102 de manière à obtenir une luminosité identique entre tous les composants émissifs 102. Pour cela, les composants photodétecteurs 112 peuvent mesurer la luminosité des composants émissifs 102 pour certaines valeurs de courant ou tension de commande appliquées sur les composants émissifs 102 (de préférence la même sur tous les composants émissifs 102 pour que les luminosités mesurées soient comparables). Les mesures obtenues peuvent être mémorisées, puis une correction des courants ou tensions de commande à appliquer sur les composants émissifs 102 peut être calculée et réalisée en fonction de ces mesures. Alternativement, des calculs peuvent être réalisés sur les mesures réalisées et les résultats de ces calculs peuvent être mémorisés et utilisés pour déterminer la correction des courants ou tensions de commande à appliquer sur les composants émissifs 102. La ou les mémoires dans lesquelles les valeurs de luminosité mesurées ou les résultats de calculs sont mémorisés peuvent être formées dans le circuit intégré 114 ou par des composants électroniques des modules distincts réalisés.

Un premier exemple de calibration des composants émissifs 102 du dispositif optoélectronique 100 est décrit ci-dessous. Dans ce premier exemple, à l'allumage des composants émissifs 102, c'est-à-dire lors de leur mise sous tension, chaque composant émissif 102 est commandé pour émettre de la lumière, par exemple en injectant un courant de valeur maximale acceptable par les composants émissifs 102 afin d'obtenir la luminosité maximale émise par les composants émissifs 102. Cette commande peut être réalisée en allumant chacun des composants émissifs 102 les uns après les autres, ou par groupes successifs de composants émissifs 102, ou bien tous les composants émissifs 102 à la fois. Lorsque chaque pixel de l'écran formé par les composants émissifs 102 comporte plusieurs composants émissifs 102 chacun destiné à émettre une lumière d'une longueur d'onde donnée, les composants émissifs 102 de chaque pixel ne sont pas allumés simultanément afin de pouvoir calibrer séparément les composants émissifs 102 destinés à émettre des longueurs d'onde différentes.

La luminosité des composants émissifs 102 allumés est ensuite mesurée et stockée en mémoire. Un calcul local de compensation est ensuite réalisé lorsque l'on voudra émettre de la lumière correspondant à la valeur souhaitée
Pour simplifier le calcul à réaliser pour calibrer les composants émissifs 102, il est possible de supposer que la luminosité varie linéairement avec la valeur du courant ou de la tension de commande appliquée, et qu'il n'existe qu'un décalage de pente à compenser. La calibration réalisée consiste dans ce cas à déterminer et appliquer un coefficient de correction sur la valeur du courant ou de la tension de commande envoyée en entrée de chacun des composants émissifs 102.

Il est toutefois possible de calibrer des dispositifs émissifs 102 pour lesquels la luminosité obtenue en sortie ne varie pas linéairement avec la valeur du courant ou de la tension de commande appliquée en entrée des composants émissifs 102. Dans ce cas, plusieurs mesures peuvent être réalisées avec divers courants injectés pour déterminer plusieurs valeurs de coefficients correctifs à appliquer en fonction de la valeur du courant ou de la tension de commande.

Une telle calibration peut être réalisée analogiquement et/ou numériquement. Les composants électroniques réalisant cette calibration peuvent être disposés dans le circuit intégré 114 ou dans chaque module comprenant les composants émissifs 102 et les composants photodétecteurs 112.

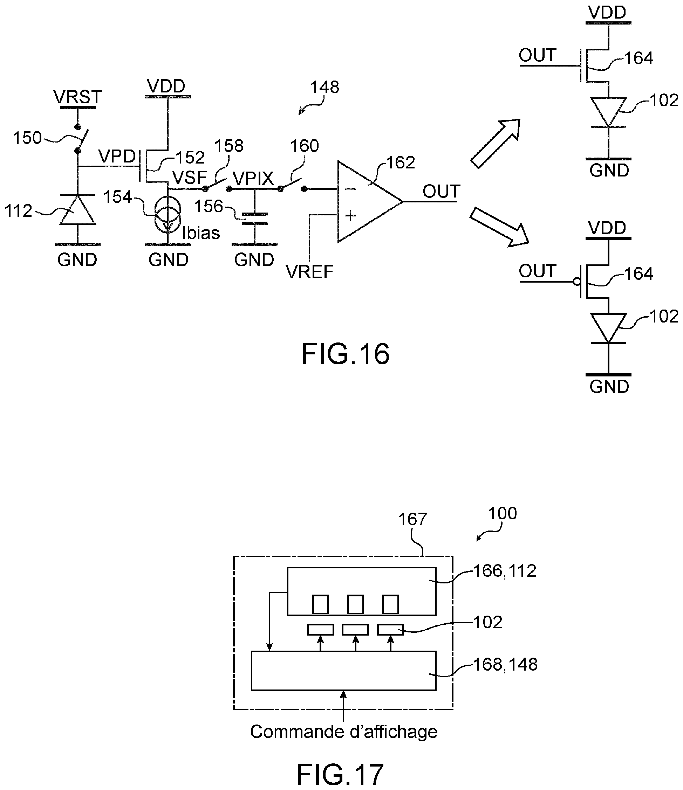

La figure 16 représente schématiquement un exemple de réalisation d'un dispositif 148 de compensation d'une tension de commande d'un composant émissif 102 en fonction de la valeur de luminosité mesurée du composant émissif 102, pouvant mettre en œuvre une calibration telle que décrite ci-dessus.

Ce dispositif 148 comporte un interrupteur 150, par exemple formé par un transistor, servant à appliquer une tension de réinitialisation VRST sur le composant photodétecteur 112 (ici une photodiode). Le dispositif 148 comporte également un transistor 152, ici de type NMOS, couplé à une source de courant de polarisation 154. La grille du transistor 152 étant reliée au composant photodétecteur 112, le transistor 152 a donc une fonction de « suiveur de tension » sur la tension VPD obtenue aux bornes du composant photodétecteur 112. La tension VPD se retrouve recopiée (à VGS près, c'est-à-dire la tension entre la grille et la source du transistor 152) sur la source du transistor 152 (correspondant à la tension VSF sur la figure 16). La valeur de la tension VSF est mémorisée dans une capacité 156 lorsque l'interrupteur 158 est actif. Sur la figure 16, la tension aux bornes de la capacité 156 est appelée VPIX. La capacité 156 est également couplée, par l'intermédiaire d'un autre interrupteur 160, à une première entrée (entrée inverseuse sur l'exemple de la figure 16) d'un comparateur 162. La valeur moyenne des tensions mesurées par les autres composants photodétecteurs 112, appelée VREF sur la figure 16, est appliquée sur la deuxième entrée (entrée non inverseuse sur l'exemple de la figure 16) du comparateur 162. Selon que la luminosité mesurée par le composant photodétecteur 112 soit au-dessus ou en-dessous de la moyenne, la tension délivrée en sortie du comparateur 162 sera ajustée. Par exemple, si la tension délivrée en sortie du composant photodétecteur 112 est inférieure à la moyenne, cela signifie, dans l'exemple décrit ici, que le composant émissif 102 est plus lumineux que la moyenne. La tension de commande appliquée sur un transistor de pilotage 164 du composant émissif 102, correspondant à la tension de sortie du comparateur 162 sera alors ajustée (baissée dans le cas d'un transistor de pilotage 164 de type NMOS, ou augmentée dans le cas d'un transistor de pilotage 164 de type PMOS).

Un tel dispositif 148 est par exemple utilisé lorsque les composants émissifs 102 sont commandés par une tension de commande modulée PWM (modulation par largeur d'impulsion), dans lequel la valeur de la luminosité à afficher par chaque composant émissif 102 est fonction de la durée pendant laquelle chaque composant émissif 102 est allumé avec sa luminosité maximale.

Dans un tel dispositif 148, le dispositif optoélectronique 100 est indirectement asservi car la valeur de la tension de sortie du composant photodétecteur 112 va modifier la valeur de la tension de commande obtenue en sortie du comparateur 162 qui va elle-même influer sur la luminance émise par le composant émissif 102 et par conséquent sur la lumière captée par le composant photodétecteur 112.

La valeur moyenne des tensions délivrées en sortie des composants photodétecteurs 112 peut par exemple être calculée une seule fois, avant de procéder à la phase de correction. Alternativement, cette valeur moyenne peut également être calculée de façon dynamique et rafraîchie régulièrement.

Dans le dispositif 148 décrit ci-dessus, la mesure et le calcul de la valeur moyenne des tensions délivrées en sortie des composants photodétecteurs 112 doivent être régulièrement répétées, par exemple toutes les 5 à 10 images affichées par la matrice de composants émissifs 102, du fait que cette valeur est mémorisée dans des capacités.

En variante, il est possible que chaque colonne de la matrice de composants émissifs soit couplée à une entrée d'un convertisseur analogique - numérique dont la sortie est couplée à l'entrée d'une mémoire, une sortie de la mémoire étant couplée à l'entrée d'un convertisseur numérique - analogique, et la sortie du convertisseur numérique - analogique est couplée aux grilles des transistors d'attaque des composants émissifs 102 de la colonne. Dans ce cas, lors de la phase de calibration, la valeur de la tension de sortie du comparateur 162 de chaque pixel d'une même colonne est lue, une ligne après l'autre. Cette valeur est alors convertie en valeur numérique, pour être stockée dans la mémoire (ou éventuellement utilisée pour des calculs dont les résultats sont ensuite mémorisés). Régulièrement, par exemple toutes les 5-10 images, les valeurs mémorisées sont délivrées en sortie de la mémoire puis converties en valeurs analogiques et réinjectées dans les pixels, par exemple sur les capacités Cgs des transistors d'attaque des composants émissifs 102.

Un deuxième exemple de calibration du dispositif optoélectronique 100 est décrit ci-dessous et représenté schématiquement sur la figure 17. Dans ce deuxième exemple, le dispositif optoélectronique 100 comporte un dispositif 166 de mesure de luminosité externe au circuit comprenant les composants émissifs 102 et les composants photodétecteurs 112. Par exemple, des signaux de commande de valeurs croissantes (par exemple numériques) sont appliqués, via le circuit de commande portant la référence 168 sur la figure 17, en entrée d'un ou plusieurs composants émissifs 102 jusqu'à obtenir des valeurs de luminosité souhaitées mesurées par le dispositif 166 de mesure de luminosité externe. Lorsque la luminosité cible est atteinte, le dispositif 100 peut alors réaliser une mesure de luminosité par les composants photodétecteurs 112, ces mesures pouvant être ensuite stockées dans une mémoire non volatile intégrée au circuit 166. Une compensation, par exemple similaire à celle précédemment décrite dans le premier exemple précédent, peut alors être réalisée par le dispositif de calcul de compensation 148.

Dans l'exemple de réalisation représenté sur la figure 17, les composants émissifs 102, les composants photodétecteurs 112 et les circuits 148, 168 et 166 peuvent être formés sous la forme de modules 167 indépendants reportés sur un support, comme précédemment décrits.

Les premier et deuxième exemples de calibration précédemment décrits sont avantageusement mis en œuvre pour un dispositif 100 dont les composants émissifs 102 forment des pixels tous séparés physiquement sous la forme de modules 167 reportés sur un support et formant un grand écran.

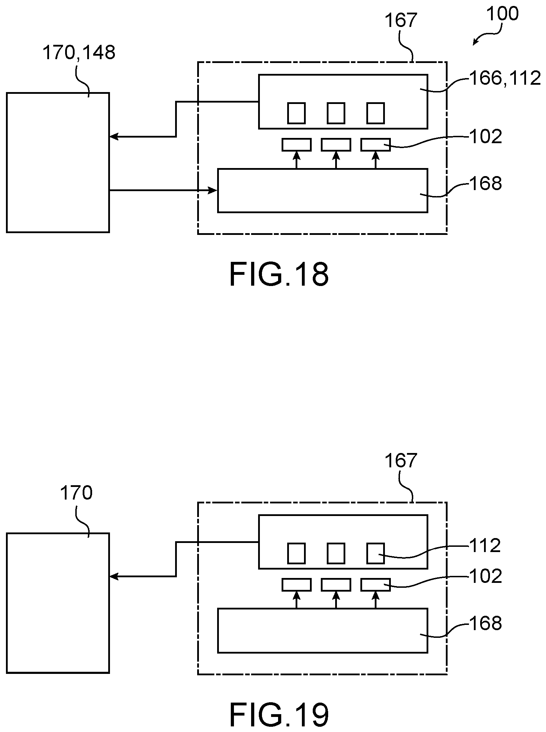

En variante du deuxième exemple de calibration décrit ci-dessus, la mémoire non volatile dans laquelle sont mémorisées les valeurs de luminosité mesurées par le dispositif 166 de mesure de luminosité externe peut être externe au circuit comprenant les composants émissifs 102 et les composants photodétecteurs 112. Dans ce cas, cette mémoire peut être localisée dans une carte vidéo 170 avec laquelle communiquent le dispositif 166 de mesure de luminosité externe et le circuit comprenant les composants émissifs 102 et les composants photodétecteurs 112. Dans cette configuration représentée schématiquement sur la figure 18, la carte vidéo 170 peut également inclure le dispositif de calcul de compensation 148.

De manière complémentaire ou alternative aux différents exemples de calibration décrits ci-dessus, les composants photodétecteurs 112 du dispositif optoélectronique 100 peuvent servir à réaliser une capture d'image et/ou une détection. Dans ce cas, les informations de luminosité capturées par les composants photodétecteurs 112 peuvent être envoyées dans la carte vidéo 170 avec laquelle communiquent les composants photodétecteurs 112. Par exemple, il est possible de détecter une présence via l'ombre produite sur le dispositif optoélectronique 100 avec une lumière externe, telle que la silhouette d'une personne ou l'ombre d'une main ou d'un doigt (par exemple lorsque dispositif optoélectronique 100 forme un écran tactile). Cette détection peut être réalisée lorsque les composants émissifs 102 n'émettent pas de lumière, mais également lorsqu'une partie seulement des composants émissifs 102 émet de la lumière (les données provenant des composants photodétecteurs 112 qui sont disposés sous les composants émissifs 102 qui sont allumés sont ignorées). Une telle configuration est représentée schématiquement sur la figure 19.

Le dispositif 100 peut être utilisé pour d'autres applications, par exemple comme micro-afficheur de lunettes AR (Réalité Augmentée) et/ou VR (Réalité Virtuelle), pour laquelle la fonction de capture par les composants photodétecteurs 102 permet la mise en œuvre d'une fonction de suivi du regard (« eye tracking » en anglais).

## Revendications

1. Dispositif optoélectronique (100) comprenant au moins :
- un composant émissif (102) comportant au moins une première électrode (104), une deuxième électrode (108), et un élément émissif (110) disposé entre une face émissive (106) du dispositif optoélectronique (100) et la deuxième électrode (108) ;
- un composant photodétecteur (112) tel que la deuxième électrode (108) du composant émissif (102) soit disposée entre le composant photodétecteur (112) et l'élément émissif (110) ;
dans lequel :
- le composant émissif (102) et le composant photodétecteur (112) sont superposés l'un au-dessus de l'autre,
**caractérisé en ce que**
- la deuxième électrode (108) est traversée par au moins un trou (124) disposé à l'aplomb d'au moins une partie (128) d'une surface de détection (126) du composant photodétecteur (112), et/ou une partie (129) de la surface de détection (126) du composant photodétecteur (112) n'est pas disposée à l'aplomb de la deuxième électrode (108) et forme une couronne se trouvant au niveau de bords extérieurs de la surface de détection (126) du composant photodétecteur (112).

2. Dispositif optoélectronique (100) selon la revendication 1, dans lequel le composant photodétecteur (112) fait partie d'un circuit intégré (114) ou d'un module électronique (167) comprenant d'autres composants électroniques configurés pour commander au moins le composant photodétecteur (112) et le composant émissif (102) et/ou mémoriser au moins une valeur de mesure destinée à être délivrée en sortie du composant photodétecteur (112).

3. Dispositif optoélectronique (100) selon l'une des revendications précédentes, dans lequel le composant photodétecteur (112) est configuré pour mesurer une valeur de luminosité du composant émissif (102) et/ou une valeur de luminosité d'une lumière reçue à travers la face émissive (106) du dispositif optoélectronique (100).

4. Dispositif optoélectronique (100) selon la revendication 3, comportant en outre au moins un dispositif (148) de calcul de compensation d'un signal de commande du composant émissif (102) en fonction au moins de la valeur de luminosité mesurée du composant émissif (102).

5. Dispositif optoélectronique (100) selon l'une des revendications précédentes, dans lequel, dans la variante où la deuxième électrode (108) est traversée par au moins un trou (124), le trou (124) comporte, dans un plan parallèle à la surface de détection (126) du composant photodétecteur (112), une section circulaire.

6. Dispositif optoélectronique (100) selon l'une des revendications précédentes, dans lequel le composant émissif (102) fait partie d'une matrice de composants émissifs (102), et comprenant en outre plusieurs autres composants photodétecteurs (112) tels que la deuxième électrode (108) d'au moins une partie des composants émissifs (102) soit traversée par au moins un trou (124) disposé à l'aplomb d'au moins une partie (128) d'une surface de détection (126) d'un des composants photodétecteurs (112) et/ou tels qu'une partie (129) de la surface de détection (126) d'un des composants photodétecteurs (112) ne soit pas disposée à l'aplomb de la deuxième électrode (108) d'au moins un des composants émissifs (102).

7. Dispositif optoélectronique (100) selon la revendication 6, comportant en outre au moins :
- une première couche diélectrique (116) recouvrant au moins les composants photodétecteurs (112) et des premiers plots de connexion (118) disposés dans la première couche diélectrique (116) ;
- une deuxième couche diélectrique (120) recouvrant au moins les composants émissifs (102) et des deuxièmes plots de connexion (122) disposés dans la deuxième couche diélectrique (120) ;
et dans lequel la première couche diélectrique (116) est solidarisée à la deuxième couche diélectrique (120), et les premiers plots de connexion (118) sont solidarisés aux deuxièmes plots de connexion (122).

8. Dispositif optoélectronique (100) selon les revendications 2 et 7, dans lequel, lorsque le composant photodétecteur (112) fait partie d'un circuit intégré (114), les premiers plots de connexions (118) sont couplés électriquement à des portions d'un niveau d'interconnexions du circuit intégré (114) par des vias (134).

9. Dispositif optoélectronique (100) selon la revendication 6, dans lequel les composants émissifs (102) et les composants photodétecteurs (112) forment des modules (167) distincts les uns des autres, reportés sur un support et comprenant chacun au moins un des composants émissifs (102) et un des composants photodétecteurs (112).

10. Procédé de réalisation d'un dispositif optoélectronique (100), comprenant au moins :
- réalisation d'au moins un composant émissif (102) comportant au moins une première électrode (104), une deuxième électrode (108), et un élément émissif (110) disposé entre une face émissive (106) du dispositif optoélectronique (100) et la deuxième électrode (108) ;
- réalisation d'au moins un composant photodétecteur (112) tel que la deuxième électrode (108) du composant émissif (102) soit disposée entre le composant photodétecteur (112) et l'élément émissif (110), et tel que le composant émissif (102) et le composant photodétecteur (112) soient superposés l'un au-dessus de l'autre ;
**caractérisé en ce que**
la deuxième électrode (108) est traversée par au moins un trou (124) disposé à l'aplomb d'au moins une partie (128) d'une surface de détection (126) du composant photodétecteur (112) et/ou dans lequel une partie (129) de la surface de détection (126) du composant photodétecteur (112) n'est pas disposée à l'aplomb de la deuxième électrode (108) et forme une couronne se trouvant au niveau de bords extérieurs de la surface de détection (126) du composant photodétecteur (112).

11. Procédé selon la revendication 10, dans lequel le composant photodétecteur (112) est réalisé dans un circuit intégré (114) ou un module électronique (167) comprenant d'autres composants électroniques configurés pour commander au moins le composant photodétecteur (112) et le composant émissif (102) et/ou mémoriser au moins une valeur de mesure destinée à être délivrée en sortie du composant photodétecteur (112).

12. Procédé selon l'une des revendications 10 ou 11, comportant en outre :
- après la réalisation du composant photodétecteur (112), la réalisation d'au moins une première couche diélectrique (116) recouvrant au moins le composant photodétecteur (112) et la réalisation de premiers plots de connexion (118) dans la première couche diélectrique (116) ;
- après la réalisation du composant émissif (102), la réalisation d'au moins une deuxième couche diélectrique (120) recouvrant au moins le composant émissif (102) et la réalisation de deuxièmes plots de connexion (122) dans la deuxième couche diélectrique (120) ;
- solidarisation par collage direct de la première couche diélectrique (116) contre la deuxième couche diélectrique (120), et des premiers plots de connexion (118) contre les deuxièmes plots de connexion (122).

## Patentansprüche

1. Optoelektronische Vorrichtung (100), die mindestens Folgendes umfasst:
- eine Emissionskomponente (102), die mindestens eine erste Elektrode (104), eine zweite Elektrode (108) und ein Emissionselement (110) umfasst, das zwischen einer emittierenden Seite (106) der optoelektronischen Vorrichtung (100) und der zweiten Elektrode (108) angeordnet ist;
- eine Fotodetektorkomponente (112), so dass die zweite Elektrode (108) der Emissionskomponente (102) zwischen der Fotodetektorkomponente (112) und dem Emissionselement (110) angeordnet ist;
wobei:
- die Emissionskomponente (102) und die Fotodetektorkomponente (112) übereinander liegen,
**dadurch gekennzeichnet, dass**
- die zweite Elektrode (108) von mindestens einem Loch (124) durchquert wird, das senkrecht zu mindestens einem Teil (128) einer Detektionsfläche (126) der Fotodetektorkomponente (112) angeordnet ist, und/oder ein Teil (129) der Detektionsfläche (126) der Fotodetektorkomponente (112) nicht senkrecht zur zweiten Elektrode (108) angeordnet ist und einen Ring bildet, der sich an den Außenkanten der Detektionsfläche (126) der Fotodetektorkomponente (112) befindet.

2. Optoelektronische Vorrichtung (100) nach Anspruch 1, wobei die Fotodetektorkomponente (112) Teil einer integrierten Schaltung (114) oder eines elektronischen Moduls (167) ist, die bzw. das andere elektronische Komponenten umfasst, die so eingerichtet sind, dass sie mindestens die Fotodetektorkomponente (112) und die Emissionskomponente (102) steuern und/oder mindestens einen Messwert speichern, der am Ausgang der Fotodetektorkomponente (112) ausgegeben werden soll.

3. Optoelektronische Vorrichtung (100) nach einem der vorhergehenden Ansprüche, wobei die Fotodetektorkomponente (112) so eingerichtet ist, dass sie einen Helligkeitswert der Emissionskomponente (102) und/oder einen Helligkeitswert eines durch die emittierende Seite (106) der optoelektronischen Vorrichtung (100) empfangenen Lichts misst.

4. Optoelektronische Vorrichtung (100) nach Anspruch 3, ferner umfassend mindestens eine Vorrichtung (148) zur Kompensation eines Steuersignals der Emissionskomponente (102) in Abhängigkeit von mindestens dem gemessenen Helligkeitswert der Emissionskomponente (102).

5. Optoelektronische Vorrichtung (100) nach einem der vorhergehenden Ansprüche, wobei in der Variante, bei der die zweite Elektrode (108) von mindestens einem Loch (124) durchquert wird, das Loch (124) in einer Ebene parallel zur Detektionsfläche (126) der Fotodetektorkomponente (112) einen kreisförmigen Querschnitt aufweist.

6. Optoelektronische Vorrichtung (100) nach einem der vorhergehenden Ansprüche, wobei die Emissionskomponente (102) Teil einer Matrix von Emissionskomponenten (102) ist, und ferner mehrere andere Fotodetektorkomponenten (112) umfasst, wobei z. B. die zweite Elektrode (108) mindestens eines Teils der Emissionskomponenten (102) von mindestens einem Loch (124) durchquert wird, das senkrecht zu mindestens einem Teil (128) einer Detektionsfläche (126) einer der Fotodetektorkomponenten (112) angeordnet ist, und/oder wobei z. B. ein Teil (129) der Detektionsfläche (126) einer der Fotodetektorkomponenten (112) nicht senkrecht zur zweiten Elektrode (108) mindestens einer der Emissionskomponenten (102) angeordnet ist.

7. Optoelektronische Vorrichtung (100) nach Anspruch 6, die ferner mindestens Folgendes umfasst:
- eine erste dielektrische Schicht (116), die mindestens die Fotodetektorkomponenten (112) und erste Kontaktflächen (118) bedeckt, die in der ersten dielektrischen Schicht (116) angeordnet sind;
- eine zweite dielektrische Schicht (120), die mindestens die Emissionskomponenten (102) und zweite Kontaktflächen (122) bedeckt, die in der zweiten dielektrischen Schicht (120) angeordnet sind;
und wobei die erste dielektrische Schicht (116) fest mit der zweiten dielektrischen Schicht (120) verbunden ist, und die ersten Kontaktflächen (118) fest mit den zweiten Kontaktflächen (122) verbunden sind.

8. Optoelektronische Vorrichtung (100) nach Anspruch 2 und 7, wobei, wenn die Fotodetektorkomponente (112) Teil einer integrierten Schaltung (114) ist, die ersten Kontaktflächen (118) über Vias (134) elektrisch mit Abschnitten einer Verbindungsebene der integrierten Schaltung (114) gekoppelt sind.

9. Optoelektronische Vorrichtung (100) nach Anspruch 6, wobei die Emissionskomponenten (102) und die Fotodetektorkomponenten (112) voneinander getrennte Module (167) bilden, auf einen Träger übertragen und jeweils mindestens eine der Emissionskomponenten (102) und eine der Fotodetektorkomponenten (112) umfassen.

10. Verfahren zum Herstellen einer optoelektronischen Vorrichtung (100), das mindestens Folgendes umfasst:
- Herstellen mindestens einer Emissionskomponente (102), die mindestens eine erste Elektrode (104), eine zweite Elektrode (108) und ein Emissionselement (110) umfasst, das zwischen einer emittierenden Seite (106) der optoelektronischen Vorrichtung (100) und der zweiten Elektrode (108) angeordnet ist;
- Herstellen mindestens einer Fotodetektorkomponente (112), so dass die zweite Elektrode (108) der Emissionskomponente (102) zwischen der Fotodetektorkomponente (112) und dem Emissionselement (110) angeordnet ist, und so dass die Emissionskomponente (102) und die Fotodetektorkomponente (112) übereinander liegen;
**dadurch gekennzeichnet, dass**
die zweite Elektrode (108) von mindestens einem Loch (124) durchquert wird, das senkrecht zu mindestens einem Teil (128) einer Detektionsfläche (126) der Fotodetektorkomponente (112) angeordnet ist, und/oder wobei ein Teil (129) der Detektionsfläche (126) der Fotodetektorkomponente (112) nicht senkrecht zur zweiten Elektrode (108) angeordnet ist und einen Ring bildet, der sich an den Außenkanten der Detektionsfläche (126) der Fotodetektorkomponente (112) befindet.

11. Verfahren nach Anspruch 10, wobei die Fotodetektorkomponente (112) in einer integrierten Schaltung (114) oder einem elektronischen Modul (167) hergestellt ist, die bzw. das andere elektronische Komponenten umfasst, die so eingerichtet sind, dass sie mindestens die Fotodetektorkomponente (112) und die Emissionskomponente (102) steuern und/oder mindestens einen Messwert speichern, der am Ausgang der Fotodetektorkomponente (112) ausgegeben werden soll.

12. Verfahren nach einem der Ansprüche 10 oder 11, das ferner Folgendes umfasst:
- nach dem Herstellen der Fotodetektorkomponente (112), Herstellen mindestens einer ersten dielektrischen Schicht (116), die mindestens die Fotodetektorkomponente (112) bedeckt, und Herstellen erster Kontaktflächen (118) in der ersten dielektrischen Schicht (116);
- nach dem Herstellen der Emissionskomponente (102) Herstellen mindestens einer zweiten dielektrischen Schicht (120), die mindestens die Emissionskomponente (102) bedeckt, und Herstellen zweiter Kontaktflächen (122) in der zweiten dielektrischen Schicht (120);
- festes Verbinden der ersten dielektrischen Schicht (116) mit der zweiten dielektrischen Schicht (120) und der ersten Kontaktflächen (118) mit den zweiten Kontaktflächen (122) durch Verkleben.

## Claims

1. Optoelectronic device (100) comprising at least:
- an emissive component (102) including at least a first electrode (104), a second electrode (108), and an emissive element (110) disposed between an emissive face (106) of the optoelectronic device (100) and the second electrode (108);
- a photodetector component (112) such that the second electrode (108) of the emissive component (102) is disposed between the photodetector component (112) and the emissive element (110);
wherein:
- the emissive component (102) and the photodetector component (112) are superimposed one above the other, **characterised in that**
- the second electrode (108) has at least one hole (124) passing through it, disposed vertically in line with at least a part (128) of a detection surface (126) of the photodetector component (112) and/or a part (129) of the detection surface (126) of the photodetector component (112) is not disposed vertically in line with the second electrode (108) and form a ring located at the external edges of the detection surface (126) of the photodetector component (112).

2. Optoelectronic device (100) according to claim 1, wherein the photodetector component (112) forms part of an integrated circuit (114) or of an electronic module (167) comprising other electronic components configured to control at least the photodetector component (112) and the emissive component (102) and/or configured to store at least one measurement value intended to be delivered as an output of the photodetector component (112).

3. Optoelectronic device (100) according to one of the preceding claims, wherein the photodetector component (112) is configured to measure a luminosity value of the emissive component (102) and/or to measure a luminosity value of a light received through the emissive face (106) of the optoelectronic device (100).

4. Optoelectronic device (100) according to claim 3, furthermore including at least one device (148) for calculating compensation of a control signal of the emissive component (102) according to at least the measured luminosity value of the emissive component (102).

5. Optoelectronic device (100) according to any one of the preceding claims wherein, in the alternative in which the second electrode (108) has at least one hole (124) passing through it, the hole (124) includes, in a plane parallel to the detection surface (126) of the photodetector component (112), a circular cross section.

6. Optoelectronic device (100) according to any one of the preceding claims, wherein the emissive component (102) forms part of a matrix of emissive components (102), and furthermore comprising a plurality of other photodetector components (112) such that the second electrode (108) of at least some of the emissive components (102) has at least one hole (124) passing through it disposed vertically in line with at least a part (128) of a detection surface (126) of one of the photodetector components (112) and/or such that a part (129) of the detection surface (126) of one of the photodetector components (112) is not disposed vertically in line with the second electrode (108) of at least one of the emissive components (102).

7. Optoelectronic device (100) according to claim 6, furthermore including at least:
- a first dielectric layer (116) covering at least the photodetector components (112) and first connection pads (118) disposed in the first dielectric layer (116);
- a second dielectric layer (120) covering at least the emissive components (102) and second connection pads (122) disposed in the second dielectric layer (120);
and wherein the first dielectric layer (116) is secured to the second dielectric layer (120), and the first connection pads (118) are secured to the second connection pads (122).

8. Optoelectronic device (100) according to claims 2 and 7 wherein, when the photodetector component (112) forms part of an integrated circuit (114), the first connection pads (118) are electrically coupled to portions of an interconnection level of the integrated circuit (114) by vias (134).

9. Optoelectronic device (100) according to claim 6, wherein the emissive components (102) and the photodetector components (112) form modules (167) distinct from each other, attached to a support and each comprising at least one of the emissive components (102) and one of the photodetector components (112).

10. Method for producing an optoelectronic device (100), comprising at least:
- producing at least one emissive component (102) including at least a first electrode (104), a second electrode (108), and an emissive element (110) disposed between an emissive face (106) of the optoelectronic device (100) and the second electrode (108);
- producing at least one photodetector component (112) such that the second electrode (108) of the emissive component (102) is disposed between the photodetector component (112) and the emissive element (110), and such that the emissive component (102) and the photodetector component (112) are superimposed one above the other; **characterised in that**
the second electrode (108) has at least one hole (124) passing through it disposed vertically in line with at least a part (128) of a detection surface (126) of the photodetector component (112) and/or wherein a part (129) of the detection surface (126) of the photodetector component (112) is not disposed vertically in line with the second electrode (108) and form a ring located at the external edges of the detection surface (126) of the photodetector component (112).

11. Method according to claim 10, wherein the photodetector component (112) is implemented in an integrated circuit (114) or an electronic module (167) comprising other electronic components configured for controlling at least the photodetector component (112) and the emissive component (102) and/or storing at least one measurement value intended to be delivered as an output of the photodetector component (112).

12. Method according to one of claims 10 or 11, furthermore including:
- after the production of the photodetector component (112), producing at least a first dielectric layer (116) covering at least the photodetector component (112) and producing first connection pads (118) in the first dielectric layer (116);
- after the production of the emissive component (102), producing at least one second dielectric layer (120) covering at least the emissive component (102) and producing second connection pads (122) in the second dielectric layer (120);
- securing, by direct bonding, the first dielectric layer (116) against the second dielectric layer (120), and first connection pads (118) against the second connection pads (122).
